# EUROPEAN PATENT SPECIFICATION

(11) **EP 3 264 112 B1**
(45) Date of publication and mention of the grant of the patent: **10.04.2019**
(21) Application number: 17179000.9
(22) Date of filing: 30.06.2017
(51) Int. Cl.: G01R 31/02

(54) **METHOD FOR DETECTING A DC MAGNETIC BIAS IN TRANSFORMER**
VERFAHREN ZUR DETEKTION EINER GLEICHSTROMMAGNETISIERUNG IN EINEM TRANSFORMATOR
PROCÉDÉ DE DÉTECTION D'UNE POLARISATION MAGNÉTIQUE DE COURANT CONTINU DANS UN TRANSFORMATEUR

(30) Priority: 30.06.2016 CN 201610515033
(43) Date of publication of application: 03.01.2018
(73) Proprietor: Siemens Transformer Company Ltd., Guangzhou, Guangdong 510530 (CN)
(72) Inventor: LI, Lin Da, Guangzhou 510530 (CN); FAN, Xing Hua, Guangzhou 510530 (CN); SI, Dai Jun, 510760 Guangzhou (CN)
(74) Representative: Patentanwaltskanzlei WILHELM & BECK

(56) References cited:
- CN-A- 101 246 043
- JP-A- 2001 161 024
- BOWEI LIU ET AL: "On-Line Monitoring of Transformer Vibration and Noise Based on DC Magnetic Bias", 2013 FOURTH INTERNATIONAL CONFERENCE ON INTELLIGENT SYSTEMS DESIGN AND ENGINEERING APPLICATIONS, IEEE, 6 November 2013 (2013-11-06), pages 412-416, XP032612671, DOI: 10.1109/ISDEA.2013.498 [retrieved on 2014-06-25]
- GAO P ET AL: "Application of multifractal spectrum to the vibration analyses of power transformer under DC bias", 2014 IEEE PES GENERAL MEETING | CONFERENCE & EXPOSITION, IEEE, 27 July 2014 (2014-07-27), pages 1-5, XP032670248, DOI: 10.1109/PESGM.2014.6939238 [retrieved on 2014-10-29]
- MINGDE CUI ET AL: "Application of the virtual instrument technology in the monitoring system of transformer DC magnetic bias", 2010 INTERNATIONAL CONFERENCE ON COMPUTER APPLICATION AND SYSTEM MODELING : (ICCASM 2010) ; TAIYUAN, CHINA, 22 - 24 OCTOBER 2010, IEEE, PISCATAWAY, NJ, USA, 22 October 2010 (2010-10-22), pages V4-299, XP031788998, ISBN: 978-1-4244-7235-2

## Description

### Technical field

The present invention relates to a detection method, in particular to a method for detecting DC magnetic bias in a transformer.

### Background art

Direct current (DC) magnetic bias refers to half-cycle saturation of a transformer core as a result of direct current or near-direct current entering a transformer coil from the outside and magnetizing the transformer, as well as a series of electromagnetic effects arising therefrom. DC magnetic bias is an abnormal operating state of a transformer, and may have adverse effects on the transformer and the electricity grid, e.g. increase iron consumption and copper consumption in the transformer, worsen noise and vibration, and cause harm in other ways.

At present, it is possible to determine whether DC magnetic bias has occurred in a transformer through noise and/or vibration of the transformer, but these methods are all susceptible to external influences, and so are unable to accurately diagnose DC magnetic bias.

### Content of the invention

The object of the present invention is to provide a method for detecting DC magnetic bias in a transformer, which method has low detection costs, as well as being safe, fast and highly accurate.

The present invention provides a method for detecting DC magnetic bias in a transformer, comprising the following steps: a signal acquisition step, a signal processing step and a determination step. The signal acquisition step consists of acquiring a vibration signal of an oil tank of the transformer. The signal processing step comprises: forming a time domain waveform of the vibration signal; subjecting the time domain waveform to frequency domain decomposition, to convert the time domain waveform into a frequency domain waveform; calculating an amplitude of each odd number frequency and an amplitude of each even number frequency of the frequency domain waveform. The determination step is as follows: if the amplitude of an odd number frequency is greater than half of the amplitude of an even number frequency, then there is DC magnetic bias in the transformer. The detection method described above has low detection costs, as well as being safe, fast and highly accurate.

In another schematic embodiment of the method for detecting DC magnetic bias in a transformer, the signal acquisition step further comprises arranging at least three vibration sensors on an outer surface of the oil tank of the transformer to acquire the vibration signal. The three vibration sensors are located in different positions on the outer surface of the oil tank of the transformer, helping to improve the DC magnetic bias detection result.

In another schematic embodiment of the method for detecting DC magnetic bias in a transformer, the method further comprises, before the signal acquisition step, a preparation step: keeping the transformer in an unloaded state; keeping a blower and an oil pump of the transformer in a turned-off state. The method described above can be of more help in obtaining a more accurate vibration signal.

In another schematic embodiment of the method for detecting DC magnetic bias in a transformer, the vibration sensors are connected to the outer surface of the oil tank magnetically. The adoption of such a design facilitates the installation and use of the vibration sensors.

In another schematic embodiment of the method for detecting DC magnetic bias in a transformer, in the signal processing step, the odd number frequency of 50 Hz or 150 Hz is chosen to perform calculation.

In another schematic embodiment of the method for detecting DC magnetic bias in a transformer, in the signal processing step, the even number frequency of 100 Hz is chosen to perform calculation.

In another schematic embodiment of the method for detecting DC magnetic bias in a transformer, the determination step further comprises determining the degree of severity of the DC magnetic bias by means of a ratio relationship between the amplitude of an even number frequency and the amplitude of an odd number frequency.

Preferred embodiments are explained below in a clear and easily comprehensible way with reference to the accompanying drawings, to further explain the abovementioned characteristics, technical features and advantages of the method for detecting DC magnetic bias in a transformer, and embodiments thereof.

### Description of the accompanying drawings

The accompanying drawings below merely illustrate and explain the present invention schematically, without limiting the scope thereof.
Fig. 1 is a device schematic diagram intended to illustrate detection of DC magnetic bias in a transformer.
Fig. 2 is a flow chart intended to illustrate a schematic embodiment of a method for detecting DC magnetic bias in a transformer.
Fig. 3 is a vibration frequency domain waveform graph intended to describe a transformer which has DC magnetic bias.
Fig. 4 is a vibration frequency domain waveform graph intended to describe a transformer which has no DC magnetic bias.

### Key to labels

- 10: vibration sensor
- 20: oil tank
- 22: oil tank sidewall
- 30: computer
- 40: mobile phone
- S51: preparation step
- S52: signal acquisition step
- S54: signal processing step
- S542: time domain waveform acquisition step
- S544: frequency domain waveform acquisition step
- S546: calculation step
- S56: determination step.

### Particular embodiments

To enable clearer understanding of the technical features, objectives and effects of the invention, particular embodiments of the present invention are now explained with reference to the accompanying drawings, in which identical labels indicate structurally identical components or components with similar structures but identical functions.

As used herein, "schematic" means "serving as an instance, example or illustration". No drawing or embodiment described herein as "schematic" should be interpreted as a more preferred or more advantageous technical solution.

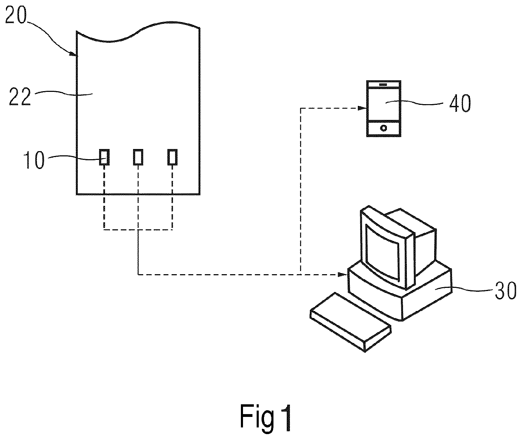

Fig. 1 is a device schematic diagram intended to illustrate detection of DC magnetic bias in a transformer. As Fig. 1 shows, before a signal is acquired, first of all three vibration sensors 10 are arranged on an outer surface of a sidewall 22 of an oil tank 20 of a transformer (the invention is not limited to this), then a computer 30 and/or a mobile terminal such as a mobile phone 40 is used to connect to each vibration sensor 10. Of course, associated devices are not limited to computers or mobile phones; other devices could also be used to connect to the vibration sensors 10.

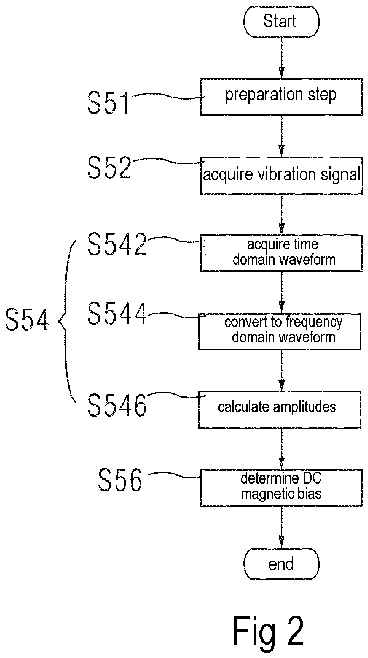

Figs. 1 and 2 may be referred to at the same time; Fig. 2 is a flow chart intended to illustrate a schematic embodiment of a method for detecting DC magnetic bias in a transformer, with step S51 being performed first.

Step S51, preparation step: the transformer is kept in an unloaded state, and a blower and oil pump of the transformer are kept in a turned-off state. Such a processing method is of more help in obtaining an accurate vibration signal. Then step S52 is performed. Of course, depending on the actual detection situation, the preparation step could also include other preparation matters, or the preparation step described above might not be performed.

Step S52, signal acquisition step: a vibration signal of the oil tank 20 of the transformer is acquired by means of the vibration sensors 10 arranged on the outer surface of the oil tank 20. Then step S54 is performed.

Step S54, signal processing step, further comprising three substeps S542, S544 and S546.

Step S542, time domain waveform acquisition step: acquiring the vibration signal by means of the computer 30 and/or the mobile terminal such as the mobile phone 40, and forming a time domain waveform of the vibration signal. Then step S544 is performed.

Step S544, frequency domain waveform acquisition step: subjecting the time domain waveform obtained in the step above to frequency domain decomposition (Fourier transform) by means of the computer 30 and/or the mobile terminal such as the mobile phone 40, to convert the time domain waveform into a frequency domain waveform. Then step S546 is performed.

Step S546, calculation step: calculating an amplitude of each odd number frequency and an amplitude of each even number frequency of the frequency domain waveform by means of the computer 30 and/or the mobile terminal such as the mobile phone 40. In general, 50 Hz or 150 Hz may be chosen for the odd number frequency, while 100 Hz may be chosen for the even number frequency. Then step S56 is performed.

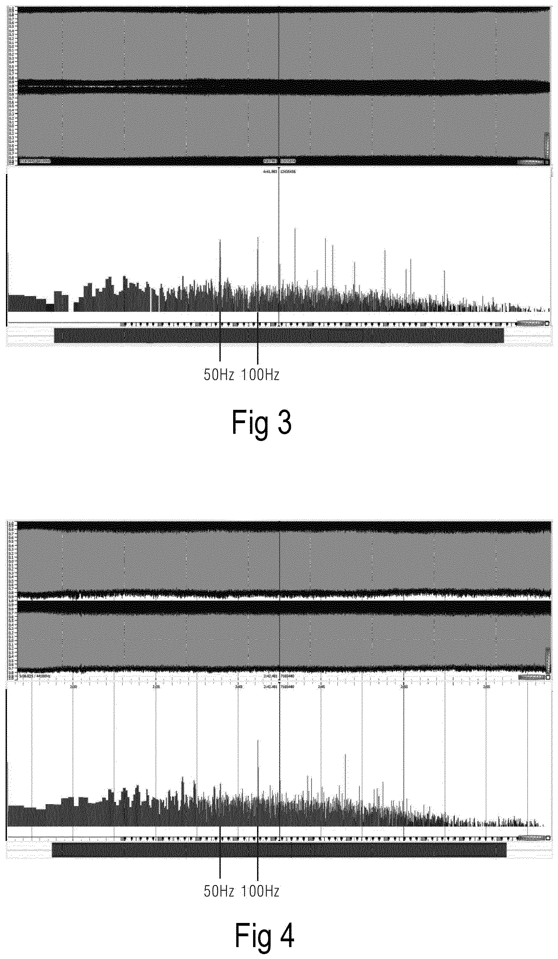

Step S56, determination step: if the amplitude of an odd number frequency is greater than half of the amplitude of an even number frequency, then there is DC magnetic bias in the transformer. As Fig. 3 shows, the amplitude at 50 Hz is greater than half of the amplitude at 100 Hz, so there is DC magnetic bias. As Fig. 4 shows, the amplitude at 50 Hz is less than half of the amplitude at 100 Hz, so there is no DC magnetic bias.

According to the DC magnetic bias detection method described above, if there is an odd harmonic component in the frequency domain waveform resulting from frequency domain decomposition, then DC magnetic bias in the transformer may be suspected. If the amplitude of an odd number frequency is greater than half of the amplitude of an even number frequency, then it can be determined that there is definitely DC magnetic bias in the transformer at the present time. The detection method described above has low detection costs, as well as being safe, fast and highly accurate.

In the embodiment shown in fig. 1, three vibration sensors 10 are provided; the three vibration sensors 10 are located in different positions on the outer surface of the oil tank 20 of the transformer, and this can be of more help in improving the DC magnetic bias detection result. Of course, depending on design requirements, different numbers of vibration sensors 10 could also be designed.

Furthermore, in a preferred embodiment, the vibration sensor 10 is connected to the outer surface of the oil tank 20 magnetically. The adoption of such a design facilitates the installation and use of the vibration sensor 10.

The determination step S56 may further comprise a step of determining the degree of severity of DC magnetic bias, i.e. after determining that there is DC magnetic bias in the transformer, the degree of severity of the DC magnetic bias may be determined by means of a ratio relationship between the amplitude of an even number frequency and the amplitude of an odd number frequency.

It should be understood that although the description herein is based on various embodiments, it is by no means the case that each embodiment contains just one independent technical solution. Such a method of presentation is adopted herein purely for the sake of clarity. Those skilled in the art should consider the description in its entirety. The technical solutions in the various embodiments could also be suitably combined to form other embodiments capable of being understood by those skilled in the art.

## Claims

1. A method for detecting DC magnetic bias in a transformer, comprising the following steps:
a signal acquisition step for acquiring a vibration signal of an oil tank (20) of the transformer;
a signal processing step, comprising:
forming a time domain waveform of the vibration signal,
subjecting the time domain waveform to frequency domain decomposition, to convert the time domain waveform into a frequency domain waveform, and
calculating an amplitude of each odd number frequency and an amplitude of each even number frequency of the frequency domain waveform; the method being **characterised by**
a determination step, wherein if the amplitude of an odd number frequency is greater than half of the amplitude of an even number frequency, then it is determined that there is DC magnetic bias in the transformer.

2. The detection method as claimed in claim 1, wherein the signal acquisition step further comprises: arranging at least three vibration sensors (10) on an outer surface of the oil tank (20) of the transformer to acquire the vibration signal.

3. The detection method as claimed in claim 1 or 2, further comprising, before the signal acquisition step, a preparation step:
keeping the transformer in an unloaded state;
keeping a blower and an oil pump of the transformer in a turned-off state.

4. The detection method as claimed in claim 2, wherein the vibration sensors (10) are connected to the outer surface of the oil tank (20) magnetically.

5. The detection method as claimed in claim 1, wherein in the signal processing step, the odd number frequency of 50 Hz or 150 Hz is chosen to perform calculation.

6. The detection method as claimed in claim 1, wherein in the signal processing step, the even number frequency of 100 Hz is chosen to perform calculation.

7. The detection method as claimed in claim 1, wherein the determination step further comprises: determining the degree of severity of the DC magnetic bias by means of a ratio relationship between the amplitude of one said even number frequency and the amplitude of one said odd number frequency.

## Patentansprüche

1. Verfahren zum Erkennen einer Gleichstromvormagnetisierung in einem Transformator, das die folgenden Schritte umfasst:
einen Signalerfassungsschritt zum Erfassen eines Vibrationssignals eines Öltanks (20) des Transformators;
einen Signalverarbeitungsschritt, umfassend:
Bilden einer Zeitbereichswellenform des Vibrationssignals,
Unterziehen der Zeitbereichswellenform einer Frequenzbereichszerlegung, um die Zeitbereichswellenform in eine Frequenzbereichswellenform zu wandeln, und
Berechnen einer Amplitude von jeder ungeradzahligen Frequenz und einer Amplitude von jeder geradzahligen Frequenz der Frequenzbereichswellenform; wobei das Verfahren durch einen Ermittlungsschritt gekennzeichnet ist, wobei, wenn die Amplitude einer ungeradzahligen Frequenz größer als die Hälfte der Amplitude einer geradzahligen Frequenz ist, ermittelt wird, dass eine Gleichstromvormagnetisierung in dem Transformator vorliegt.

2. Erkennungsverfahren nach Anspruch 1, wobei der Signalerfassungsschritt außerdem umfasst: Anordnen von mindestens drei Vibrationssensoren (10) auf einer Außenseite des Öltanks (20) des Transformators, um das Vibrationssignal zu erfassen.

3. Erkennungsverfahren nach Anspruch 1 oder 2, das außerdem vor dem Signalerfassungsschritt einen Vorbereitungsschritt umfasst:
Beibehalten des Transformators in einem ungeladenen Zustand;
Beibehalten eines Gebläses und einer Ölpumpe des Transformators in einem ausgeschalteten Zustand.

4. Erkennungsverfahren nach Anspruch 2, wobei die Vibrationssensoren (10) mit der Außenseite des Öltanks (20) magnetisch verbunden sind.

5. Erkennungsverfahren nach Anspruch 1, wobei in dem Signalverarbeitungsschritt die ungeradzahlige Frequenz von 50 Hz oder 150 Hz gewählt wird, um das Berechnen auszuführen.

6. Erkennungsverfahren nach Anspruch 1, wobei in dem Signalverarbeitungsschritt die geradzahlige Frequenz von 100 Hz gewählt wird, um das Berechnen auszuführen.

7. Erkennungsverfahren nach Anspruch 1, wobei der Ermittlungsschritt außerdem umfasst: Ermitteln des Schweregrads der Gleichstromvormagnetisierung mithilfe einer Verhältnisbeziehung zwischen der Amplitude von einer der geradzahligen Frequenzen und der Amplitude von einer der ungeradzahligen Frequenzen.

## Revendications

1. Procédé pour détecter une polarisation magnétique c.c. dans un transformateur, comprenant les étapes suivantes :
une étape d'acquisition de signal pour acquérir un signal de vibration d'une cuve à huile (20) du transformateur ;
une étape de traitement de signal, comprenant :
la formation d'une forme d'onde de domaine temporel du signal de vibration,
la soumission de cette forme d'onde de domaine temporel à une décomposition de domaine fréquentiel, afin de convertir la forme d'onde de domaine temporel en une forme d'onde de domaine fréquentiel,
le calcul d'une amplitude de chaque fréquence à nombre impair et d'une amplitude de chaque fréquence à nombre pair de la forme d'onde de domaine fréquentiel ;
ce procédé étant **caractérisé par** une étape de détermination, dans laquelle
si l'amplitude d'une fréquence à nombre impair est plus grande que la moitié de l'amplitude d'une fréquence à nombre pair, il est alors déterminé qu'il y a une polarisation magnétique c.c. dans le transformateur.

2. Procédé de détection selon la revendication 1, dans lequel l'étape d'acquisition de signal comprend en outre : la disposition d'au moins trois capteurs de vibrations (10) sur une surface extérieure de la cuve à huile (20) du transformateur afin d'acquérir le signal de vibration.

3. Procédé de détection selon la revendication 1 ou 2, comprenant en outre, avant l'étape d'acquisition de signal, une étape de préparation :
maintenant le transformateur dans un état déchargé ;
maintenant une soufflante et une pompe à huile du transformateur dans un état arrêté.

4. Procédé de détection selon la revendication 2, dans lequel les capteurs de vibrations (10) sont connectés à la surface extérieure de la cuve à huile (20) magnétiquement.

5. Procédé de détection selon la revendication 1, dans lequel, lors de l'étape de traitement de signal, on choisit la fréquence de nombre impair de 50 Hz ou 150 Hz pour exécuter le calcul.

6. Procédé de détection selon la revendication 1, dans lequel, lors de l'étape de traitement de signal, on choisit la fréquence à nombre pair de 100 Hz pour exécuter le calcul.

7. Procédé de détection selon la revendication 1, dans lequel l'étape de détermination comprend en outre : la détermination du degré de sévérité de la polarisation magnétique c.c. au moyen d'une relation de rapport entre l'amplitude d'une dite fréquence à nombre pair et l'amplitude d'une dite fréquence à nombre impair.
